# EUROPEAN PATENT SPECIFICATION

(11) **EP 1 900 540 B1**
(45) Date of publication and mention of the grant of the patent: **03.03.2010**
(21) Application number: 06731381.7
(22) Date of filing: 07.04.2006
(51) Int. Cl.: B41M 5/26, C23C 14/34, G11B 7/243, G11B 7/254, G11B 7/257, G11B 7/26

(54) **OPTICAL DISK, AND SPUTTERING TARGET FOR Cu ALLOY RECORDING LAYER**
OPTISCHER DATENTRÄGER UND SPUTTER-TARGET FÜR EINE CU-LEGIERUNGS-AUFZEICHNUNGSSCHICHT
DISQUE OPTIQUE ET CIBLE DE PULVÉRISATION CATHODIQUE POUR UNE COUCHE D ENREGISTREMENT EN ALLIAGE DE CU

(30) Priority: 04.07.2005 JP 2005195318
(43) Date of publication of application: 19.03.2008
(73) Proprietor: Nippon Mining & Metals Co., Ltd., Minato-ku Tokyo 105-0001 (JP)
(72) Inventor: SATO, Kenji, Isohara Factory of Nikko Mat. Co. Ltd, Kitaibaraki-shi, Ibaraki 319-1535 (JP)
(74) Representative: Hoarton, Lloyd Douglas Charles
(86) International application number: PCT/JP2006/307434
(87) International publication number: WO 2007/004344

(56) References cited:
- JP-A- 2 056 746
- JP-A- 05 069 671
- JP-A- 56 124 136
- JP-A- 57 140 845
- JP-A- 60 186 825
- JP-A- 61 194 658
- JP-A- 62 247 060
- JP-A- 2002 172 861
- JP-A- 2004 079 022
- DATABASE WPI Week 198749 Thomson Scientific, London, GB; AN 1987-344336 XP002507880 & JP 62 247060 A (MITSUBISHI DENKI KK) 28 October 1987 (1987-10-28)
- DATABASE WPI Week 198641 Thomson Scientific, London, GB; AN 1986-268155 XP002507881 & JP 61 194658 A (HITACHI LTD) 29 August 1986 (1986-08-29)

## Description

### TECHNICAL FIELD

The present invention generally relates to an optical disk and a sputtering target for a Cu alloy recording layer, and in particular relates to an optical disk and a sputtering target for a Cu alloy recording layer capable of obtaining an optical recording medium with no error in the recording bit when a protective layer containing ZnS (for instance, ZnS-SiO₂) is used.

### BACKGROUND ART

In recent years, high-density recordable optical disk technology capable of recording/reproduction without requiring a magnetic head has been developed, and is rapidly attracting attention. This optical disk can be classified into three categories of read-only, recordable and rewritable. Particularly, the phase change method employed in the recordable optical disks (write-once recording) is demanded of high-speed recording and large-capacity writing.

This kind of optical disk records information by heating and increasing the temperature of a recording thin film on a substrate by irradiating a laser beam thereto, and generating a change in the structure of such recording thin film. More specifically, the reproduction of information is conducted by detecting the change in the reflectivity caused by the change in the optical constant.

The aforementioned phase change is performed with the irradiation of a laser beam narrowed down to a diameter of approximately 1 to several µm. Here, for example, when a 1µm laser beam passes through at a linear velocity of 10m/S, light is irradiated to a certain point on the optical disk for 100ns, and it is necessary to generate the foregoing crystallographic change and detect reflectivity within such time frame.

Further, in realizing the foregoing crystallographic change, a compatible optical recording medium is being sought.

Generally, an optical disk has a structure where a recording layer is sandwiched by protective layers, or a structure where one side of a recording layer is covered with a protective layer. Further, the use of Cu/Si as the recording layer of next-generation optical disks has been proposed (Non-Patent Document 1). Laser is irradiated to the Cu recording layer for reacting Cu and Si, and the crystal structure in the structure between Cu and Si is changed for recording. This is only for writing once, and no editing or rewriting is allowed.

To briefly explain the disk described in Non-Patent Document 1, it is a write-once disk of dual structure and inorganic material system with the use of blue laser light. This disk has a sandwich structure, where a Cu alloy layer is provided adjacent to a Si layer and the recording medium is sandwiched by protective layers. Further, this sandwich structure is formed as a dual structure via a spacer layer, and is disposed on a PC (polycarbonate) substrate via a reflective layer. A cover layer is provided on the surface layer.

In this example, although a Cu alloy recording layer is shown, there is no particular reference to the alloy component. Further, since a copper or a copper alloy recording layer is still in its infancy, the favorable aspects are not sufficiently unknown. As a protective layer, a material containing ZnS (for instance, ZnS-SiO₂) is used. Incidentally, the following example explains a case of using this ZnS-SiO₂ as the protective layer.

It has become known that a serious problem arises between the copper recording layer and the ZnS-SiO₂ protective layer. The problem is that the S existing in the protective layer is dispersed to the Cu and corrodes the Cu to form opaque CuS. It causes alteration in the recording layer and misreading of the recorded information.

In order to prevent the dispersion from the protective layer, it is possible to form a transparent barrier layer for preventing such dispersion between the recording layer and the ZnS-SiO₂ protective layer. Nevertheless, the addition of a barrier layer is not preferable since it leads to an increase in the manufacturing cost. Therefore, the optimal strategy would be to devise the Cu recording layer so that it could prevent sulfuration on its own.

Nevertheless, even when using a Cu alloy for preventing the sulfuration of Cu, what kind of additive component would be optimal is virtually unknown. As described below, since the addition of alloy elements to Cu may promote the sulfuration of Cu as the recording layer, it is not necessarily appropriate.

Generally speaking, although research is being conducted on alloys for simply preventing the sulfuration of Cu, when adopting the laminated structure as an optical disk where the recording layer is sandwiched by ZnS-SiO₂ protective layers, the cause of sulfuration is not necessarily clear, and the current status is that there is no knowledge on what is optimal as the recording layer.
[Non-Patent Document 1] Hiroyasu Inoue (and four others) "Dual-Layer Inorganic Write-Once Disc based on Blu-ray Disc Format" International Symposium on Optical Memory 2003 11/3-7 Zenki Technical Digest P.50
JP 62247060 discloses an optical information recording medium that uses a Cu-Zn alloy of a shape memory alloy composition employing martenistic phase 5 transformation as its recording principle. Consequently, the Zn content in D1 is within the range 38.5-41.5at%.

### DISCLOSURE OF THE INVENTION

The present invention relates to an optical disk and a sputtering target for a Cu alloy recording layer. Particularly when a protective layer consists of ZnS (for instance, ZnS-SiO₂), this invention aims at providing the technology that prevents or inhibits sulfuration of the Cu recording layer caused by the dispersion of S from the protective layer and enables obtaining an optical recording medium with no error in the recording bit.

In order to overcome the foregoing problems, as a result of intense study, the present inventors discovered that it is possible to suppress the influence from the dispersion of S from the protective layer by adding an alloy component, which is adaptable to the recording layer, to Cu.

Based on the foregoing discovery, when an optical disk has a structure where a recording layer is adjacent to a protective layer containing ZnS, the present invention provides the optical disk with a Cu alloy recording layer that contains one or more components selected from Zn, Mn, Ga, Ti and Ta in a total amount of 1 to 20at% and the remnants composed of Cu and inevitable impurities. 4

This technology enables to effectively prevent the damage caused by S dispersing from a protective layer containing ZnS (for instance, ZnS-SiO₂), and the formation of opaque CuS and Cu₂S caused by the sulfuration of Cu.

Further, with the optical disk of the present invention, the impurities composed of Mg, Na, Ca, Ba, Ce, Li and Zr existing in the Cu alloy recording layer are respectively 0.1 at% or less. When impurities exist in excess of 0.1 at%, it becomes difficult to inhibit the damage caused by S dispersing from a protective layer containing ZnS, and may contrarily promote the sulfuration of Cu. Thus, it is desirable that the impurities are reduced as much as possible.

Further, the present invention forms the Cu alloy recording layer through sputtering, and the sputtering target for the Cu alloy recording layer itself is made to be a copper alloy containing one or more components selected from Zn, Mn, Ga, Ti and Ta in a total amount of 1 to 20at%, and the remnants composed of Cu and inevitable impurities. In this sputtering target for the Cu alloy recording layer, it is desirable that the impurities composed of Mg, Na, Ca, Ba, Ce, Li and Zr existing in the Cu alloy are respectively 0.1 at% or less.

The optical disk and the sputtering target for a Cu alloy recording layer of the present invention are capable of obtaining an optical recording medium that prevents or inhibits sulfuration of the Cu recording layer caused by the dispersion of S from the protective layer and is error free in the recording bit, particularly when a protective layer consists of ZnS (for instance, ZnS-SiO₂). Thus, the present invention yields superior effects as an optical disk and a sputtering target for a Cu alloy recording layer capable of high-speed recording and large-capacity writing.

### BRIEF DESCRIPTION OF THE DRAWINGS

Fig. 1(a) shows the relation of the standard free energy of formation of sulfides and the temperature;
Fig. 2(b) shows the relation of the standard free energy of formation of sulfides and the temperature;
Fig. 3 is a diagram showing the measured results of the reflectance ratio of the anticorrosion acceleration test when Zn is added as per Example 1 ;
Fig. 4 is a diagram showing the measured results of the reflectance ratio of the anticorrosion acceleration test when Mn is added as per Example 2;
Fig. 5 is a diagram showing the measured results of the reflectance ratio of the anticorrosion acceleration test when Al is added as per Comparative Example 1;
Fig. 6 is a diagram showing the measured results of the reflectance ratio of the anticorrosion acceleration test when Mg is added as per Comparative Example 2; and
Fig. 7 is a diagram showing the measured results of the reflectance ratio of the anticorrosion acceleration test when B is added as per Comparative Example 3.

### BEST MODE FOR CARRYING OUT THE INVENTION

The background and details of the present invention are now explained.

Generally, in order to prevent oxidization with alloys, a dense oxide film is formed on the metal surface, and such dense oxide film is used to prevent oxidization from advancing any further. For example, while Al is a material with strong oxidizing power, since dense Al₂O₃ is formed on the surface, oxidization will not advance any further, and this becomes a material with extremely superior corrosion resistance. MgO is also a similar material.

Thus, as additive agents to be added to the parent material, it is considered effective to select a material in which the standard free energy of formation of oxides is small.

When utilizing this phenomenon of oxidization, it would be considered appropriate to select a material having standard free energy of formation of sulfides that is smaller than Cu, the parent material, as additive agent to be added to Cu.

Nevertheless, as shown in the Examples described later, there were cases where it was not possible to prevent sulfuration even when a material having standard free energy of formation of sulfides that is smaller than Cu as the parent material was selected.

When adding Al, which is a material having standard free energy of formation of sulfides that is much smaller than Cu as the parent material, although there was some anticorrosion (sulfuration prevention) effect, this was insufficient (Comparative Example 1 described later). When adding Mg, this actually promoted the sulfuration of Cu (Comparative Example 2 described later).

Next, B was selected as a material having standard free energy of formation of sulfides that is slightly higher than Cu. B is considerably higher than the standard free energy of formation of sulfides of Zn, but is only slightly lower or equal to Cu. In this case, as expected, the addition of B actually promoted the sulfuration of Cu (Comparative Example 3 described later).

Meanwhile, when adding Mn and Zn as shown in Examples 1 and 2 described later, extremely high anticorrosion (sulfuration prevention) effects were attained. The commonality of these additives is that they are additive materials having similar standard free energy of formation as, for instance, ZnS of ZnS-SiO₂ used as a protective layer. Contrarily, when this difference becomes large, no effect can be achieved as in the case of Al and Mg described above.

In other words, it has become known that elements that form sulfides having standard free energy of formation in a range of ±20 from -112kcal/mol S2, which is the standard free energy of formation of ZnS at 300K, are useful. Incidentally, 300K is a temperature close to room temperature. Since recording mediums are stored at room temperature, corrosion in a state of room temperature will become problematic. Therefore, the behavior of ZnS at 300K is important.

As substances that adapt to the foregoing conditions, there are metal elements selected from Zn, Mn, Ga, Ti and Ta. Furthermore, the addition of these elements at 1 to 20at% is effective. It has become known that no effect will be yielded if the added amount is less than 1 at%, and it is undesirable to add these elements exceeding 20at% since the function as a Cu recording layer will deteriorate.

Although the reason for this kind of phenomenon is not necessarily evident theoretically, the reason is speculated to be as follows.

Generally speaking, ZnS is a stable compound when Zn and S are in a ratio of 1:1. Nevertheless, the composition will not necessarily be a stoichiometric composition of 1:1, and there are cases where the compositional range will be Zn-rich and S-rich.

When the composition is Zn-rich, the activity of S of ZnS (value showing the activity ratio of S, and the larger the activity, the more sulfurized the component) is small, CuS or Cu₂S which is unstable as sulfides is not formed, and thereby corrosion caused by sulfuration will not occur.

Meanwhile, when the composition is S-rich, the activity of S of ZnS is large, CuS or Cu₂S which is unstable as sulfides is formed, and thereby corrosion caused by sulfuration will occur.

Like this, ZnS of the composition used as a protective layer is formed through sputtering, and, when a S-rich portion is partially formed or the overall sputtering target is formed to be S-rich, the composition will be directly reflected on the film, and it is likely that a S-rich layer will be formed on the entire surface of the film. In this kind of case, a S-rich ZnS is considered to cause the corrosion of Cu.

Accordingly, by adding a material that is more stable as a sulfide than Cu, it is considered that the active S (free S) stemming from ZnS preferentially bonds with the additive agent to form a dense film, and thereby prevents the sulfuration of Cu.

This additive agent, as described above, is a metal element selected from Zn, Mn, Ga, Ti and Ta, and Zn and Mn are particularly effective. Since these sulfides themselves are transparent and do not absorb light, they do not deteriorate the function as a recording layer.

Meanwhile, although Mg is an element that has small standard free energy of formation and forms stable sulfides, Mg promotes the dissociation of S from ZnS and makes ZnS unstable, and it is considered that Mg promotes the creation of active S and deteriorates the function as a protective film.

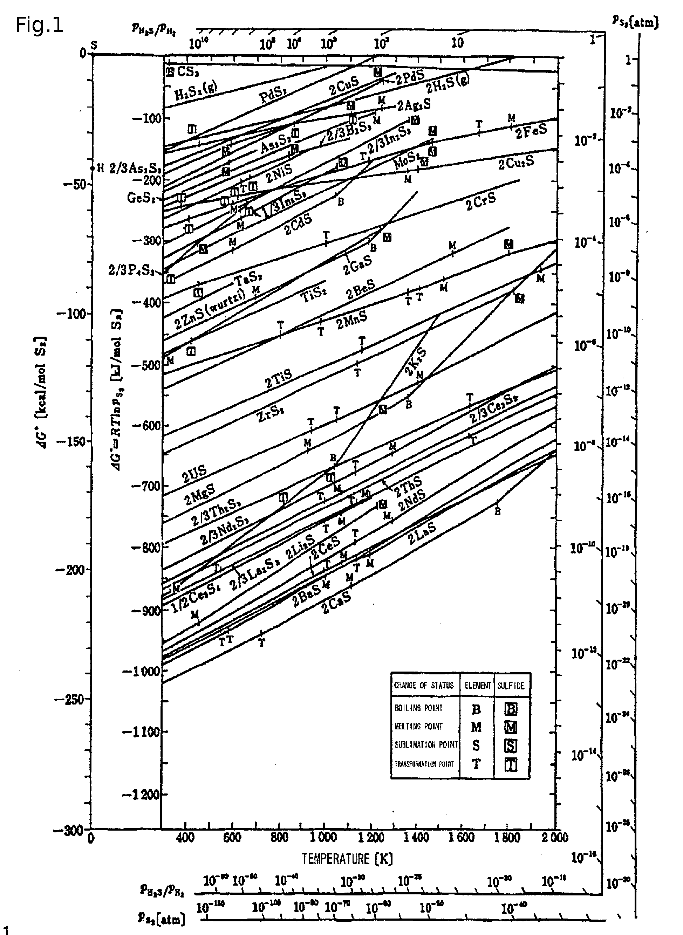

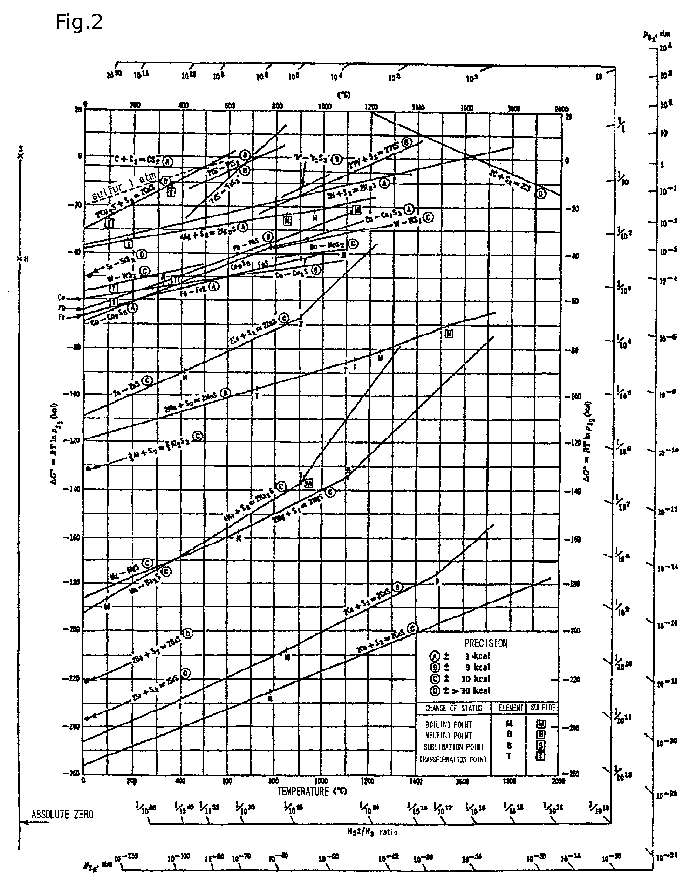

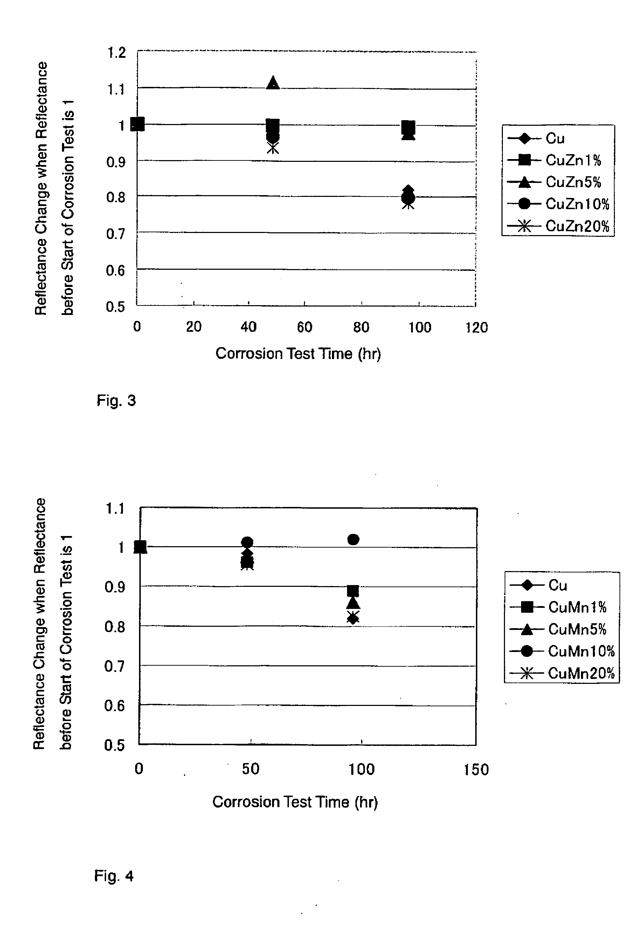

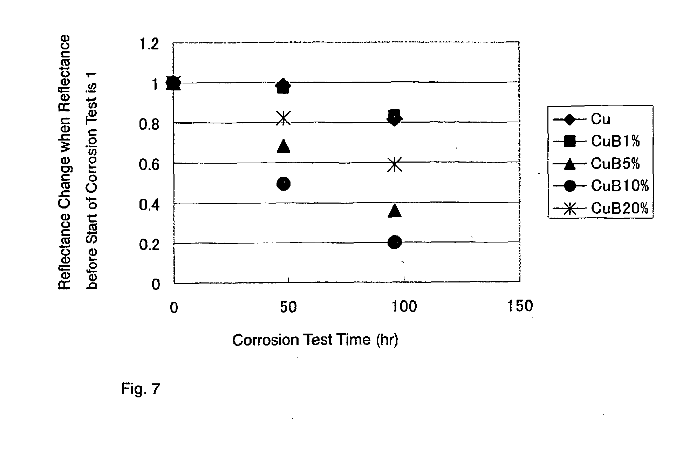

Further, B having slightly smaller standard free energy of formation than CuS is not active enough to prevent the formation of CuS, and the addition of B is ineffective. By way of reference, the relationship of the range of standard free energy of formation of sulfides and the temperature is shown in Fig. 1 and Fig. 2. Incidentally, the source of Fig. 1 is Iron and Steel Handbook (3rd Edition), Volume 1, Page 12 "Basic Theory (Figs. 1 and 3(b) Relation of Standard Free Energy of Formation of Sulfides and Temperature)," and the Iron and Steel Institute of Japan, issued by Maruzen (October 30, 1981; Second Print). The source of Fig. 2 is Thermodynamics of Solids by Swalin, Figs. 7 and 8 "Relation of Standard Free Energy of Formation of Sulfides and Temperature," issued by Corona (March 25, 1992; 15^{th} Print).

Accordingly, the elements that promote the creation of active S and deteriorate the function of a protective film due to dissociation of S from ZnS and destabilization of ZnS, and the elements that are not active enough to prevent the formation of CuS, are harmful as impurities in Cu.

Therefore, it is desirable to reduce such impurities as much as possible. These elements, as described above, are Mg, Na, Ca, Ba, Ce, Li and Zr, and it is desirable that these impurities are respectively kept to be 0.1 at% or less.

### [Examples]

The present invention is now described with reference to the Examples and Comparative Examples. These Examples are merely illustrative, and the present invention shall in no way be limited thereby. In other words, the present invention shall only be limited by the scope of claim for a patent, and shall include the various modifications other than the Examples of this invention.

### (Example 1)

Materials in which 1 at%, 5at%, 10at% and 20at% of Zn were added to Cu were respectively formed into an ingot with an arc-melting furnace, and the ingot was used to prepare four types of Cu-Zn alloy samples. Further, for comparison, Cu ingots were similarly prepared. After polishing the surface of these samples, etching was performed with nitric acid, and a ZnS-SiO₂ film was additionally formed thereon.

These samples were subject to an anticorrosion test. The anticorrosion test involved an acceleration test at constant temperature and humidity (85°C, 85%, 100 hours). The appearance of corrosion was compared by visual observation and reflectance ratio measurement before and after the acceleration test. The results of this anticorrosion test based on visual observation are shown in Table 1. Further, the reflectance ratio measured results are shown in Fig. 3. Incidentally, Table 1 shows the comprehensive evaluation of the standard free energy of formation of sulfides ΔG[kcal/mol S2] and the anticorrosion of the respective additive elements at 300K.

The standard free energy of formation of ZnS at 300K is -112kcal/mol S2, and the anticorrosion effect when adding Zn as an additive material having the same standard free energy of formation of sulfides as ZnS was extremely high and favorable. Further, as shown in Fig. 3, although the reflectance ratio decreased slightly than the corrosion test of Cu only in the long-term acceleration test of 100 hours with the additive amount of Zn at 20at%, the other tests hardly showed any decrease in the reflectance ratio, and it is evident that the addition of Zn is extremely effective.

### (Example 2)

Materials in which 1 at%, 5at%, 10at% and 20at% of Mn were added to Cu were respectively formed into an ingot with an arc-melting furnace, and the ingot was used to prepare four types of Cu-Mn alloy samples. Further, for comparison, Cu ingots were similarly prepared. After polishing the surface of these samples, etching was performed with nitric acid, and a ZnS-SiO₂ film was additionally formed thereon.

These samples were subject to an anticorrosion test. The anticorrosion test involved an acceleration test at constant temperature and humidity (85°C, 85%, 100 hours). The appearance of corrosion was compared by visual observation and reflectance ratio measurement before and after the acceleration test. The results of this anticorrosion test are shown in Table 1. Further, the reflectance ratio measured results are shown in Fig. 4.

As shown in Table 1, the anticorrosion effect when adding Mn as an additive material having standard free energy of formation of sulfides similar to ZnS was extremely high and favorable. Further, as shown in Fig. 4, the reflectance ratio in the case of adding Mn was the same or more favorable than Cu, and hardly showed any decrease in the reflectance ratio. Thus, it is evident that the addition of Mn is extremely effective.

Further, ΔG of Ga is -117, ΔG of Ti is -116, and ΔG of Ta is -102. These are all elements that form sulfides having standard free energy of formation in a range of ±20 from -112kcal/mol S2, which is the standard free energy of formation of ZnS at 300K. Accordingly, the addition of these elements also yields similar effects as with Zn and Mn. Further, similar effects were also yielded with the compound addition of these elements.

### (Comparative Example 1)

Materials in which 1at%, 5at%, 10at% and 20at% of Al were added to Cu were respectively formed into an ingot with an arc-melting furnace, and the ingot was used to prepare four types of Cu-Al alloy samples. Further, for comparison, Cu ingots were similarly prepared. After polishing the surface of these samples, etching was performed with nitric acid, and a ZnS-SiO₂ film was additionally formed thereon.

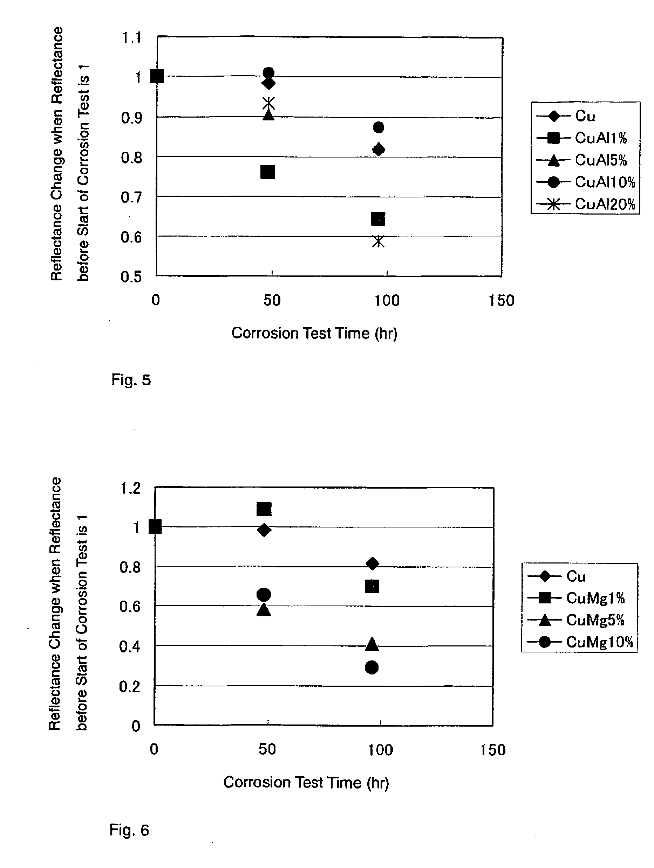

These samples were subject to an anticorrosion test. The anticorrosion test involved an acceleration test at constant temperature and humidity (85°C, 85%, 100 hours). The appearance of corrosion was compared by visual observation and reflectance ratio measurement before and after the acceleration test. The results of this anticorrosion test are shown in Table 1. Further, the reflectance ratio measured results are shown in Fig. 5.

As shown in Table 1, the anticorrosion effect when adding Al as an additive material having standard free energy of formation of sulfides dissimilar to ZnS was slightly inferior. Further, as shown in Fig. 5, the reflectance ratio in the case of adding Al varied significantly in comparison to Cu alone, and showed considerable decrease overall with the progress of the anticorrosion test. Thus, it is evident that the addition of Al is significantly inferior.

**[Table 1]**

| | Additive Element | ΔG[kcal/mol S2] | Anticorrosion Effect |
|---|---|---|---|
| | | 300K | |
| Example 1 | Zn | -112 | High |
| Example 2 | Mn | -124 | High |
| Comparative Example 1 | Al | -134 | Slightly Inferior |
| Comparative Example 2 | Mg | -183 | Significantly Inferior |
| Comparative Example 3 | B | -60 | Significantly Inferior |

### (Comparative Example 2)

Materials in which 1at%, 5at%, 10at% and 20at% of Mg were added to Cu were respectively formed into an ingot with an arc-melting furnace, and the ingot was used to prepare four types of Cu-Mg alloy samples. Further, for comparison, Cu ingots were similarly prepared. After polishing the surface of these samples, etching was performed with nitric acid, and a ZnS-SiO₂ film was additionally formed thereon.

These samples were subject to an anticorrosion test. The anticorrosion test involved an acceleration test at constant temperature and humidity (85°C, 85%, 100 hours). The appearance of corrosion was compared by visual observation and reflectance ratio measurement before and after the acceleration test. The results of this anticorrosion test are shown in Table 1. Further, the reflectance ratio measured results are shown in Fig. 6.

As shown in Table 1, the anticorrosion effect when adding Mg as an additive material having standard free energy of formation of sulfides significantly dissimilar to ZnS was considerably inferior. Further, as shown in Fig. 6, the reflectance ratio in the case of adding Mg varied significantly in comparison to Cu alone, and showed considerable decrease overall with the progress of the anticorrosion test. Thus, it is evident that the addition of Mg is significantly inferior.

### (Comparative Example 3)

Materials in which 1at%, 5at%, 10at% and 20at% of B were added to Cu were respectively formed into an ingot with an arc-melting furnace, and the ingot was used to prepare four types of Cu-B alloy samples. Further, for comparison, Cu ingots were similarly prepared. After polishing the surface of these samples, etching was performed with nitric acid, and a ZnS-SiO₂ film was additionally formed thereon.

These samples were subject to an anticorrosion test. The anticorrosion test involved an acceleration test at constant temperature and humidity (85°C, 85%, 100 hours). The appearance of corrosion was compared by visual observation and reflectance ratio measurement before and after the acceleration test. The results of this anticorrosion test are shown in Table 1. Further, the reflectance ratio measured results are shown in Fig. 7.

As shown in Table 1, the anticorrosion effect when adding B as an additive material having standard free energy of formation of sulfides significantly dissimilar to ZnS was considerably inferior. Further, as shown in Fig. 7, the reflectance ratio in the case of adding B varied significantly in comparison to Cu alone, and showed considerable decrease overall with the progress of the anticorrosion test. Thus, it is evident that the addition of B is significantly inferior.

### INDUSTRIAL APPLICABILITY

The optical disk and the sputtering target for a Cu alloy recording layer of the present invention are capable of obtaining an optical recording medium that prevents or inhibits sulfuration of the Cu recording layer caused by the dispersion of S from the protective layer and is error free in the recording bit, particularly when a protective layer consists of ZnS (for instance, ZnS-SiO₂). Thus, the present invention yields superior effects as an optical disk and a sputtering target for a Cu alloy recording layer capable of high-speed recording and large-capacity writing.

## Claims

1. An optical disk with a Cu alloy recording layer that contains one or more components selected from Zn, Mn, Ga, Ti and Ta in a total amount of 1 to 20at% and the remnants composed of Cu and inevitable impurities, wherein the optical disk has a structure where a recording layer is adjacent to a protective layer containing ZnS.

2. The optical disk comprising a Cu alloy recording layer according to claim 1, wherein the impurities composed of Mg, Na, Ca, Ba, Ce, Li and Zr existing in said Cu alloy recording layer are respectively 0.1at% or less.

3. A sputtering target for a Cu alloy recording layer containing one or more components selected from Zn, Mn, Ga, Ti and Ta in a total amount of 1 to 20at% and the remnants composed of Cu and inevitable impurities.

4. A sputtering target for a Cu alloy recording layer according to claim 3, wherein the impurities composed of Mg, Na, Ca, Ba, Ce, Li and Zr existing in said Cu alloy are respectively 0.1 at% or less.

## Patentansprüche

1. Optische Platte mit einer Cu-Legierungsaufzeichnungsschicht, die eine oder mehrere aus Zn, Mn, Ga, Ti und Ta ausgewählte Komponenten in einer Gesamtmenge von 1 bis 20 Atomprozent und die aus Cu und unvermeidbaren Fremdkörpern bestehenden Reststoffe enthält, wobei die optische Platte eine Struktur aufweist, in der eine Aufzeichnungsschicht sich neben einer ZnS enthaltenden Schutzschicht befindet.

2. Optische Platte, die eine Cu-Legierungsaufzeichnungsschicht gemäß Anspruch 1 umfasst, wobei die aus Mg, Na, Ca, Ba, Ce, Li und Zr bestehenden Fremdkörper in der Cu-Legierungsaufzeichnungsschicht jeweils 0,1 Atomprozent oder weniger ausmachen.

3. Sputtertarget für eine Cu-Legierungsaufzeichnungsschicht, das eine oder mehrere aus Zn, Mn, Ga, Ti und Ta ausgewählte Komponenten in einer Gesamtmenge von 1 bis 20 Atomprozent und die aus Cu und unvermeidbaren Fremdkörpern bestehenden Reststoffe enthält.

4. Sputtertarget für eine Cu-Legierungsaufzeichnungsschicht gemäß Anspruch 3, wobei die aus Mg, Na, Ca, Ba, Ce, Li und Zr bestehenden Fremdkörper in der Cu-Legierung jeweils 0,1 Atomprozent oder weniger ausmachen.

## Revendications

1. Un disque optique muni d'une couche d'enregistrement en alliage de Cu qui contient un ou plusieurs composants sélectionnés parmi Zn, Mn, Ga, Ti et Ta dans une quantité totale de 1 à 20% at et les résidus composés de Cu et d'impuretés inévitables, où le disque optique possède une structure où une couche d'enregistrement est adjacente à une couche de protection contenant du ZnS.

2. Le disque optique comprenant une couche d'enregistrement en alliage de Cu selon la Revendication 1, où les impuretés composées de Mg, Na, Ca, Ba, Ce, Li et Zr existant dans ladite couche d'enregistrement en alliage de Cu sont respectivement de 0,1% at ou moins.

3. Une cible de pulvérisation pour une couche d'enregistrement en alliage de Cu contenant un ou plusieurs composants sélectionnés parmi Zn, Mn, Ga, Ti et Ta dans une quantité totale de 1 à 20% at et les résidus composés de Cu et d'impuretés inévitables.

4. Une cible de pulvérisation pour une couche d'enregistrement en alliage de Cu selon la Revendication 3, où les impuretés composées de Mg, Na, Ca, Ba, Ce, Li et Zr existant dans ledit alliage de Cu sont respectivement de 0,1 % at ou moins.
